# EUROPEAN PATENT SPECIFICATION

(11) **EP 1 013 426 B1**
(45) Date of publication and mention of the grant of the patent: **19.12.2007**
(21) Application number: 99309555.3
(22) Date of filing: 29.11.1999
(51) Int. Cl.: B41J 2/085, B41J 2/125, G01R 31/02

(54) **Short detection for ink jet printhead**
Kurzschlussnachweis für einen Tintenstrahldruckkopf
Détection de court-circuits pour une tête d'impression à jet d'encre

(30) Priority: 14.12.1998 US 211206
(43) Date of publication of application: 28.06.2000
(73) Proprietor: Eastman Kodak Company, Rochester, New York 14650 (US)
(72) Inventor: Bowers, Mark C., Ann Arbor, MI 48105 (US); Woolard, Daniel E., Ohio 45419-1855 (US); Cleary, Joseph P., Ohio 45429 (US); Katerberg, James A., Ohio 45429 (US)
(74) Representative: Weber, Etienne Nicolas

(56) References cited:
- EP-A- 0 021 560
- EP-A- 0 771 655
- US-A- 3 885 432
- US-A- 4 010 424
- US-A- 4 346 389
- US-A- 4 994 821
- US-A- 5 233 303
- US-A- 5 473 353
- PATENT ABSTRACTS OF JAPAN vol. 010, no. 142 (M-481), 24 May 1986 (1986-05-24) & JP 60 262662 A (HITACHI SEIKO KK), 26 December 1985 (1985-12-26)
- PATENT ABSTRACTS OF JAPAN vol. 005, no. 193 (M-101), 9 December 1981 (1981-12-09) & JP 56 115276 A (RICOH CO LTD), 10 September 1981 (1981-09-10)
- PATENT ABSTRACTS OF JAPAN vol. 012, no. 356 (M-745), 26 September 1988 (1988-09-26) & JP 63 112159 A (HITACHI LTD), 17 May 1988 (1988-05-17)
- PATENT ABSTRACTS OF JAPAN vol. 018, no. 065 (M-1554), 3 February 1994 (1994-02-03) & JP 05 286139 A (TOPPAN PRINTING CO LTD), 2 November 1993 (1993-11-02)

## Description

### Technical Field

The present invention relates to ink-jet printers, and more particularly, to planar charging print heads that require a means of detecting unwanted ink on a charge plate during start-up and printing and, more particularly, to improved detection of misplaced ink in the charge plate region of such printing systems.

### Background Art

Charge plates used for charging of drops in an ink jet printer are subject to being shorted out by the conductive ink. Therefore, in the field of ink jet printers, it is desirable to be able to detect unwanted ink on the charge plate during start-up and printing. The unwanted ink may be a mist build-up on or near the charge leads, but is usually an accumulation of ink on or near the charge leads caused by a crooked jet or improper start-up. The unwanted ink on the charge plate causes an electrical short between the charge leads and ground, causing print defects and physical damage to the charge plate due to unwanted current flow.

Existing charge lead short detect schemes rely on a measurement of the current drawn from the charge plate voltage supply by conductive ink bridging a charge lead to some nearby ground. This requires the current measurement to take place during the nonprint state when the charge lead voltages are all nonzero. There are several problems with the present short detect scheme.

One problem with such short detect schemes is that timing the current measurements with non-print times can be tedious to perform on long arrays, especially with possible segmented phasing. Another problem is that if the amount of ink bridging the charge leads to ground is small enough, then the current drawn from the charge lead power supply can be below the threshold needed to signal an improper condition due to high ink path resistance. Therefore, the threshold current for detecting a "short" must be made as small as possible. This is limited greatly by the externally induced noise created by the charge driver switching slew rates. This allows small, high resistance ink paths to exist without being detected for some amount of time, causing ink build-up and charge lead deplating to take place until a more catastrophic failure occurs. Additionally, if a jet is in the beginning phases of crashing where ink is only being placed at the lower portion of the charge plate region, without actually electrically contacting the charge lead, it is not detected and the print head is allowed to function even though a print problem may exist, or until a much more damaging condition is created from ink accumulating in the charge plate area.

Another existing method to provide a means of detecting such shorts so corrective actions can be taken locates two detection wires or electrodes under the charge plate. These electrodes, which are located on the upper portion of the catcher or between the charge plate and catcher, span the width of the jet array. Ink on the charge plate that would cause the charging electrodes to be shorted out will also tend to provide continuity between the two detection wires. The continuity between the detection wires could be detected by various electronic schemes. However, this short detection system has proved to be difficult and expensive to implement. Problems with this method include the difficulty of locating the wire below the charge plate in such a way that the wire did not provide any interference to the ink drops and further which was not located in a natural trap for the ink.

It is seen then that there is a need for an improved short detection technique for detecting unwanted ink on the charge plate of an ink jet printhead.

### Summary of the Invention

This need is met by the short detect technique according to the present invention, wherein two short detection electrodes are fabricated on the charge plate by the same process used to make the charging electrodes. The well defined, close spacing of these electrodes facilitates both ac and dc means for detecting shorts.

Accordingly, it is an advantage of the present invention that it provides consistency in detecting shorts. It is a further advantage of the present invention that the consistency provided by this process facilitates a combined ac and dc detection system for shorts.

The advantages are achieved by the invention as defined in the appended claims.

### Brief Description of the Drawing

Fig. 1 is a side view of a continuous ink jet system of the type suitable for use with the short detection circuit of the present invention;
Fig. 2 illustrates a portion of the electrode pattern as it is produced by the electroforming process;
Fig. 3 shows the charge plate with the two short detection electrodes as it is assembled to the top of the charge plate;
Fig. 4 is a schematic illustration of the short detection electronics of the present invention; and
Figs. 5 and 6 illustrate waveforms for an all resistive load on the two-wire sensor of the present invention and waveforms for an all capacitive load on the two-wire sensor of the present invention, respectively.

### Detailed Description of the Preferred Embodiments

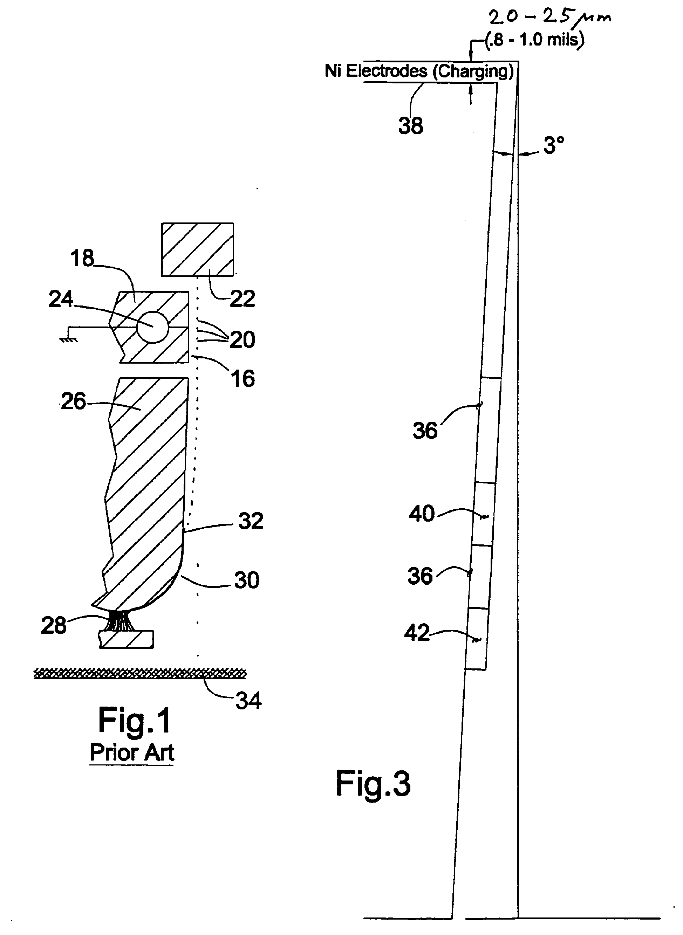

The present invention relates to the type of continuous ink jet system illustrated in Fig. 1. A plurality of jets is created at high spatial resolution by a drop generator, which stimulates the natural break-up of jets into uniform streams of droplets. A plurality of conducting elements, or charge leads 16, are located on a planar charge plate 18. A plurality of streams of drops 20 are supplied by drop generator 22. A plurality of independently switchable sources 24 of electrostatic potential are supplied to the plurality of charge leads 16. A catcher 26 intercepts the slightly deflected streams of drops. The plurality of streams of drops impacting on the catcher forms a film of ink 30, which in turn forms a flow of ink 28, sucked away from the face of the catcher by a vacuum. Reference number 32 represents the area on the catcher at which the deflected drops impact the catcher and merge together to form a film of ink on the catcher face. The undeflected ink drops then print the image on substrate 34. Of course, it will be understood that the improved short detection technique of the present invention applies to any printhead, regardless of whether deflection electrodes are employed.

In EP0771655 A2, two short detection electrodes are placed in a recess under the charge plate. When ink from a crooked jet strikes the charge plate, where it could short out the charging electrodes, it also spans the gap between the short detect electrodes, producing a low resistance between the electrodes. Electronic detection means attached to these two electrodes can detect the low resistance condition, and signal the machine control system to take corrective action. Unfortunately ink likes to collect in and is hard to remove from the recess under the charge plate. This can lead to indications of shorts even when the charge plate was clean. In the present invention, that problem is avoided by removing the detection electrodes from the recess below the charge plate and fabricating them instead on the charge plate face, flush with the charge plate face. In this location the two short detection electrodes are readily cleaned during the startup sequence and there is no mechanism to cause ink to collect on these electrodes separate from the charging electrodes.

In U.S. Patent No. 4,560,991, a method for fabricating a charge plate was described. Using photolithographic and electroforming processes, an electrode pattern could be formed on a metal substrate. The coupon, that is the substrate and the attached electrode pattern, were bent at approximately a right angle. The bent coupon was then placed into a mold, and the charge plate subsequently molded. After the molded part is fully cured or set, the substrate upon which the electrode pattern had been formed is removed by etching. In this way the desired charging electrodes and lead structure can be fabricated.

U.S. Patent No. 5,512,117 provided an improved method for charge plate fabrication. This patent formed the electrode pattern on the metal substrate in the same manner. The coupon is also bent in the same manner. Rather than using a molding process to form the charge plate, the coupon is laminated, using an adhesive, to a rigid dielectric substrate. After the adhesive has cured, the metal substrate, upon which the electrode pattern had been formed, is removed by etching as with the earlier patent. As the adhesive or the molding material fill the space between electrodes, the charging electrodes are flush with the surface of the charge plate for both of these fabrication processes.

One can fabricate a charge plate with integral short detection electrodes below the charge plate by utilizing the process described in U.S. Patent No. 4,928,113 for producing deflection electrodes below the charging electrodes. The '113 patent shows howelectrodes which are outside the active charging electrode array can extend down the charge plate face farther than the charging electrodes. The electrodes then have a right angle turn and can extend transverse across the width of the array. The '113 patent further shows how multiple transverse electrodes can be fabricated in this manner. In the '113 patent, the teaching was that such electrodes served as deflection electrodes.

In accordance with the present invention, it has been found that in the absence of a nearby ground electrode, such as on the opposite side of the jet array, and with fairly long charging electrodes, 381-508 micrometers (15- 20 mil), these extra electrodes under the charging electrodes do not produce much deflection. It is therefore possible to use these transverse electrodes as a short detection sensor without significantly affecting the catch or print drop trajectories, even if one of the electrodes is driven with an ac voltage.

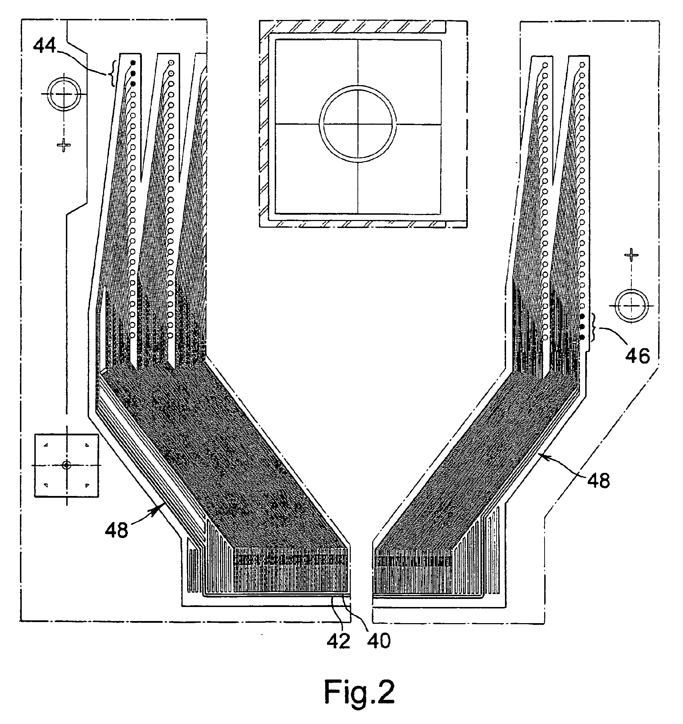

The present invention utilizes two transverse or "extra" electrodes below the charging electrode. Fig. 2 shows the electrode pattern as it is produced on a metal substrate by the electroforming process. As illustrated, upper and lower detection electrodes 40 and 42, respectively, can be formed by the same photolithographic and electroforming processes used to form the charging electrodes. The detection electrodes 40 and 42 are electrically shielded by electrical shields 48. First and second connection sites 44 and 46 connect the detection electrodes 40 and 42 to the short detection electronics at both ends of the charging electrode array. This provides some redundancy in connecting to the short detection electrodes. The coupon, the substrate and the attached electrode pattern, are bent at approximately a right angle. It is then laminated onto a rigid dielectric substrate, such as a ceramic, as described in patent '117.

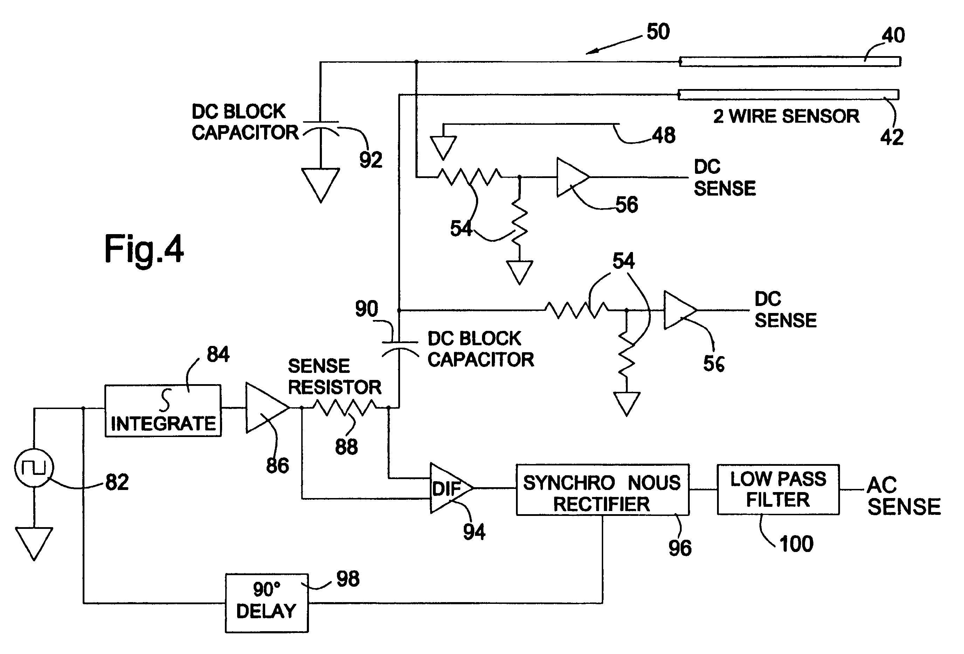

Fig. 3 shows a cross sectional view of the charge plate face. The charging electrodes 38 and the upper and lower detection electrodes 40 and 42, respectively, are shown laminated to the ceramic substrate. The epoxy 36 used in the lamination process fills the space between the electrodes. As a result, the short detection electrodes 40 and 42 are made flush with the charge plate face, so that there is no problem with these electrodes obstructing the drop flight.

Since the short detection electrode geometry is produced by the same photolithographic process used to define the charging electrodes 38, their location is well defined relative to the charging electrodes. As a result, they can be located close enough to the charging electrodes to be able to detect charge plates shorts, while being far enough away to prevent shorts in the absence of an ink bridge. Similarly, the process ensures a consistent spacing between the detection electrodes. This allows the detection circuit to be tuned for high detection sensitivity without producing false indication of shorts. For example, a preferred embodiment as illustrated in Fig. 3 has the upper detection electrode 40 spaced 127 micrometers (5 mil) below the charging electrodes. The space between the detection electrodes is 76.2 micrometers (3 mil), with each detection electrode 76.2 micrometers (3 mil) wide.

Referring now to Fig. 4, there is illustrated a schematic 50 of the dc and ac charge detection means.

This electronic design provides two complimentary means for detecting shorts. First, one can employ dc sensing to detect shorts from the charging electrodes, which are normally at high voltage, to the capacitively grounded detection electrodes. A short from the charging electrodes to the detections electrodes will raise the dc voltage on the detection electrodes, which can be detected.

The DC sensing means 52 comprise two identical circuits, each comprising two resistors 54 and an operational amplifier 56. The presence of ink on the charge plate, which provides a conductive path from the high voltage charging electrodes and the sensing electrodes, will cause the voltage of the sensing electrodes to rise. Resistors 54 comprise a voltage divider whose output is fed to operational amplifier 56 with a gain of 1. The output of the operational amplifier, which can vary from 0 to 5 volts, provides the indication of a shorting condition. The non-zero measured voltage on one or both of the dc sense outputs is an indication of a conductive path between the sense lines 40,42 and the charging electrodes 38. DC short detection requires the presence of voltage on the charging electrodes to detect a shorting condition.

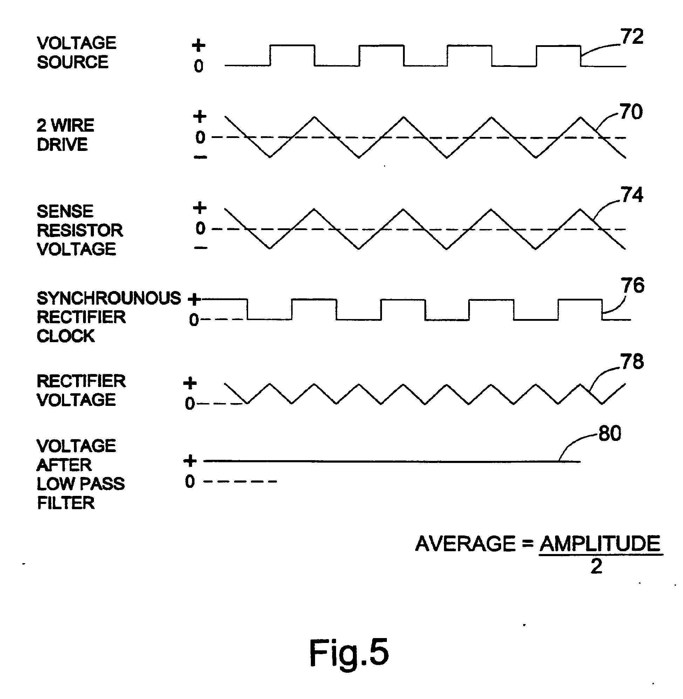

The preferred short detection circuit also provides an ac test for shorts. Referring now to Figures 4 and 5, a square wave source 82 produces a waveform 72 which is integrated by integrator 84 and buffered by amplifier 86, to produce a triangular waveform 70. The triangular waveform is applied to the series combination of a sense resistor 88, a DC blocking capacitor 90, the sense electrodes 40 and 42, and another DC blocking capacitor 92. The resistance values in the dc sensing circuits are sufficiently high that the ac current through them can be ignored. The DC blocking capacitors prevent dc currents, produced by the voltage on the charging electrodes, from flowing through the sense electrodes to ground or to the AC sense circuit. However, the DC blocking capacitors allow the passage of AC currents due to the triangular voltage 70. In operation the sense electrode 42 is capacitively, or if shorted out by moisture, resistively coupled to sense electrode 40. The AC current through the series combination of components, 88, 90, 40, 42 and 92, generates a voltage across sense resistor 88. This voltage is applied to a differential amplifier 94, which amplifies and shifts the voltage so that its reference point is now with respect to ground. The level shifted voltage is applied to synchronous rectifier 96. The synchronous rectifier has two inputs, a signal input and a clock. The synchronous rectifier 96 acts as an amplifier with a multiplier rate that switches from +1 to -1 depending on the logic level at the clock input. In this case, the clock is a square wave, produced by square wave source 82, but then shifted in phase by 90 degrees ,waveform 76, by phase shifter 98. The rectified output voltage 78 from 96 is applied to low pass filter 100.

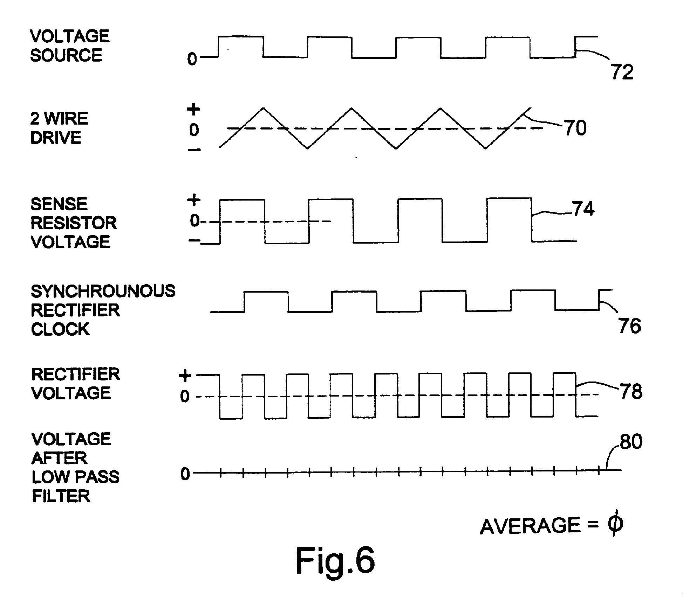

When there is no moisture present between the sensing electrodes, the sensing electrodes are capacitively coupled. The resulting voltage across the sensing resistor is then a square wave 74, as shown in Fig. 6. The synchronously rectified signal is a square wave with twice the original clock frequency that is centered about zero volts. The rectified voltage is shown as waveform 78. Passing the synchronously rectified signal through a low pass filter produces a dc signal at zero volts, as indicated by waveform 80.

Continuing with Figs. 5 and 6, if the lower detection wire is shorted to the other detection wire or some other ground by the presence of ink, the lower detection electrode becomes resistively coupled to ground. With the resistive coupling, the current flow to the detection electrode has the form of a triangle wave. The amplitude of the triangle wave depends on the resistance between the lower detection electrode and ground. When the triangle wave is passed through the synchronous rectifier, it becomes a triangle wave with twice the period of the original triangle wave. The base of the triangle wave is at zero volts rather than the triangle wave being centered around zero volts. When passed through the low pass filter, the result is a dc signal with a non-zero amplitude. The lower the resistance to ground is, the higher the output signal will be.

Utilizing this detection system which is able to distinguish resistive and capacitive coupling between the detection electrodes, allows the short detection system to be designed for greater sensitivity to shorts. Since capacitive coupling is eliminated from the output signal, the detection electrodes can be closely spaced without the increased capacitance producing false error signals. The close spacing of the detection electrodes ensures a large output signal even when only a small amount of ink bridges the two electrodes.

In a preferred embodiment, the triangle wave signal supplied to the lower detection electrode has an amplitude peak to peak of 8V. The test frequency is 5kHz. As this frequency is significantly different from the stimulation frequency or from the charge voltage switching frequencies, the detection system is therefore quite immune to noise produced in the printhead. The low frequency also minimizes the risk of the ac voltage on the detection electrode producing a detectable effect on the deflection of catch or print drops.

Since the circuit according to the present invention employs low test voltages, distinct from the high charge plate voltage, this short detect system can be activated before high voltage is supplied to the charge plate. This allows the printer to detect potentially damaging shorts before the high voltage is supplied. Also, during the normal start up sequence, moisture condenses on the charge plate. A heater is then used to dry the condensation. The drying time can depend on the environmental conditions. The use of the short detection system during start up to ensure that the drying is complete before turning on the charge plate voltage, rather than relying only on the passage of a predetermined amount of time.

## Claims

1. An ink jet printing system comprising:
a printhead comprising a charge plate having a charge plate face, the charge plate face having a plurality of associated charging electrodes (38); and
a detection means for detecting ink formed on the charge plate, the detection means comprising:
a first transverse detection electrode (40);
a second transverse detection electrode (42), the first and second transverse detection electrodes being located on the charge plate face below the plurality of charging electrodes; and
a dc sensing means for generating an output signal from the first and second transverse detection electrodes; **characterized by** the first and second transverse detection electrodes being located flush with the charge plate face.

2. A detection means as claimed in claim 1 further comprising phase sensitive detection means to eliminate capacitive coupling.

3. A detection means as claimed in claim 2 wherein the phase sensitive detection means comprise synchronous rectification (96).

4. A detection means as claimed in claim 1 further comprising a short detection output to ensure a short free condition before applying a charging voltage to the charging electrodes.

5. A detection means as claimed in claim 1 further comprising redundant connections to the detection electrodes.

6. A method for detecting shorts associated with unwanted ink on a charge plate of an ink jet printhead, the method comprising the steps of:
providing a charge plate having a charge plate face, the charge plate face having a plurality of associated charging electrodes;
providing first and second detection electrodes located on the charge plate face below the plurality of charging electrodes; and
providing ac detection means which generates an output signal and eliminates capacitive coupling from the output signal, **characterised in that** the first and second detection electrodes are located flush with the charge plate face.

7. A method as claimed in claim 6 further comprising the step of employing dc sensing to generate an output signal from the first and second detection electrodes.

8. A method as claimed in claim 6 wherein the step of providing an ac detection means further comprises the step of providing phase sensitive detection means.

9. A method as claimed in claim 6 further comprising the step of providing a dc test for shorts.

10. A method as claimed in claim 6 wherein at least one of the first and second detection electrodes are fabricated by processes used to form the charging electrodes.

## Patentansprüche

1. Tintenstrahldrucksystem mit:
einem Druckkopf, der eine Ladungsplatte mit einer Ladungsplattenseite aufweist, die eine Vielzahl zugeordneter Ladungselektroden (38) umfasst; und
einem Erfassungsmittel zum Erfassen von auf der Ladungsplatte ausgebildeter Tinte mit:
einer ersten, sich quer erstreckenden Erfassungselektrode (40);
einer zweiten, sich quer erstreckenden Erfassungselektrode (42), wobei die erste und zweite Elektrode auf der Ladungsplattenseite unterhalb der Vielzahl von Ladungselektroden angeordnet sind; und
einem Gleichstrom-Abtastmittel zum Erzeugen eines Ausgangssignals von der ersten und zweiten, quer verlaufenden Erfassungselektrode;
**dadurch gekennzeichnet, dass**
die erste und zweite, quer verlaufende Erfassungselektrode bündig mit der Ladungsplattenseite angeordnet sind.

2. Erfassungsmittel nach Anspruch 1, mit einem phasenabhängigen Erfassungsmittel zum Eliminieren einer kapazitiven Kopplung.

3. Erfassungsmittel nach Anspruch 2, worin das phasenabhängige Erfassungsmittel einen synchronen Gleichrichter (96) aufweist.

4. Erfassungsmittel nach Anspruch 1, mit einer Ausgangs-Kurzschlusserfassung zum Gewährleisten eines kurzschlussfreien Zustands vor dem Anlegen einer Ladungsspannung an die Ladungselektroden.

5. Erfassungsmittel nach Anspruch 1, mit redundanten Anschlüssen an die Erfassungselektroden.

6. Verfahren zum Erfassen von Kurzschlüssen, die unerwünschter Tinte auf einer Landungsplatte eines Tintenstrahldruckkopfs zugeordnet sind, mit den Schritten:
Bereitstellen einer Ladungsplatte mit einer Ladungsplattenseite, die eine Vielzahl zugeordneter Ladungselektroden aufweist;
Bereitstellen einer ersten und zweiten Erfassungselektrode, die auf der Ladungsplattenseite unterhalb der Vielzahl von Ladungselektroden angeordnet sind; und
Bereitstellen eines Wechselstrom-Erfassungsmittels, das ein Ausgangssignal erzeugt und eine kapazitive Kopplung vom Ausgangssignal eliminiert,
**dadurch gekennzeichnet, dass**
die erste und zweite Erfassungselektrode bündig mit der Ladungsplattenseite angeordnet sind.

7. Verfahren nach Anspruch 6, mit dem Schritt des Verwendens einer Gleichstromabtastung zum Erzeugen eines Ausgangssignals anhand der ersten und zweiten Erfassungselektrode.

8. Verfahren nach Anspruch 6, worin der Schritt des Bereitstellens eines Wechselstrom-Erfassungsmittels zudem den Schritt des Bereitstellens eines phasenabhängigen Erfassungsmittels umfasst.

9. Verfahren nach Anspruch 6, mit dem Schritt des Bereitstellens eines Wechselstromtests für Kurzschlüsse.

10. Verfahren nach Anspruch 6, worin mindestens eine der ersten und zweiten Erfassungselektroden mittels Verfahren hergestellt wird, die zum Herstellen von Ladungselektroden verwendet werden.

## Revendications

1. Système d'impression par jet d'encre comprenant :
une tête d'impression comprenant une plaque de charge ayant une surface de plaque de charge, la surface de la plaque de charge contenant une pluralité d'électrodes de charge associées (38) ; et
un dispositif de détection permettant de détecter l'encre formée sur la plaque de charge, le dispositif de détection comprenant :
une première électrode de détection transversale (40) ;
une deuxième électrode de détection transversale (42), les première et deuxième électrodes de détection transversales étant situées sur la surface de la plaque de charge sous la pluralité d'électrodes de charge ; et
un dispositif de détection de courant continu permettant de générer un signal de sortie émis par les première et deuxième électrodes de détection transversales ; **caractérisé en ce que** les première et deuxième électrodes de détection transversales sont situées de manière à affleurer la surface de la plaque de charge

2. Dispositif de détection selon la revendication 1 comprenant aussi des moyens de détection sensibles à la phase pour éliminer le couplage capacitif.

3. Dispositif de détection selon la revendication 2, dans lequel les moyens de détection sensibles à la phase comprennent la rectification synchrone (96).

4. Dispositif de détection selon la revendication 1 comprenant aussi une sortie de détection de courts-circuits pour assurer une condition exempte de courts-circuits avant d'appliquer une tension de charge aux électrodes de charge.

5. Dispositif de détection selon la revendication 1 comprenant aussi des connexions redondantes aux électrodes de détection.

6. Procédé de détection de courts-circuits associé à une encre indésirable sur une plaque de charge d'une tête d'impression par jet d'encre, le procédé comprenant les étapes de :
préparation d'une plaque de charge ayant une surface de plaque de charge, la surface de la plaque de charge contenant une pluralité d'électrodes de charge associées ;
préparation des première et deuxième électrodes de détection situées sur la surface de la plaque de charge sous la pluralité d'électrodes de charge ; et
préparation du dispositif de détection de courant alternatif qui génère un signal de sortie et élimine le couplage capacitif du signal de sortie, **caractérisé en ce que** les première et deuxième électrodes de détection sont situées de manière à affleurer la surface de la plaque de charge.

7. Procédé selon la revendication 6 comprenant aussi l'emploi de la détection de courant alternatif pour générer un signal de sortie des première et deuxième électrodes de détection.

8. Procédé selon la revendication 6, dans lequel l'étape de préparation d'un dispositif de détection de courant alternatif comprend aussi l'étape de préparation du dispositif de détection sensible à la phase.

9. Procédé selon la revendication 6 comprenant aussi l'étape de préparation d'un essai en courant continu pour les courts-circuits.

10. Procédé selon la revendication 6, dans lequel au moins l'une des première et deuxième électrodes de détection est fabriquée par des procédés utilisés pour former les électrodes de charge.
